(19) Europäisches Patentamt
European Patent Office
Office européen des brevets

(11) **EP 2 468 692 A1**

(12) **EUROPEAN PATENT APPLICATION**
published in accordance with Art. 153(4) EPC

(43) Date of publication:
**27.06.2012 Bulletin 2012/26**

(51) Int Cl.:
***C03C 3/06*** *(2006.01)* ***H01L 21/027*** *(2006.01)*

(21) Application number: **10809950.8**

(86) International application number:
**PCT/JP2010/063834**

(22) Date of filing: **16.08.2010**

(87) International publication number:
**WO 2011/021609 (24.02.2011 Gazette 2011/08)**

(84) Designated Contracting States:
**AL AT BE BG CH CY CZ DE DK EE ES FI FR GB GR HR HU IE IS IT LI LT LU LV MC MK MT NL NO PL PT RO SE SI SK SM TR**

(30) Priority: **19.08.2009 JP 2009189899**

(71) Applicant: **Asahi Glass Company, Limited Tokyo 100-8405 (JP)**

(72) Inventors:
• **KOIKE Akio Tokyo 100-8405 (JP)**
• **IWAHASHI Yasutomi Tokyo 100-8405 (JP)**
• **KIKUGAWA Shinya Tokyo 100-8405 (JP)**

(74) Representative: **Müller-Boré & Partner Patentanwälte Grafinger Straße 2 81671 München (DE)**

(54) **TIO2-CONTAINING SILICIA GLASS, AND OPTICAL MEMBER FOR EUV LITHOGRAPHY**

(57)    The present invention relates to a $TiO_2$-containing silica glass having a $TiO_2$ content of 7.5 to 12% by mass, a fictive temperature of 1,000°C or higher, and a temperature at which a coefficient of linear thermal expansion is 0 ppb/°C being within th range of 40 to 110°C.

FIG. 2

EP 2 468 692 A1

**Description**

Technical Field

**[0001]** [0001] The present invention relates a $TiO_2$-containing silica glass (hereinafter referred to as "$TiO_2$-$SiO_2$ glass" in this specification), and in particular, to a $TiO_2$-$SiO_2$ glass to be used as an optical member of an exposure tool for EUV lithography. The EUV (extreme ultraviolet) light as referred to in the invention means light having a wavelength in a soft X-ray region or a vacuum ultraviolet region, specifically light having a wavelength of from about 0.2 to 100nm.

Background Art

In the photolithography technology, an exposure tool for manufacturing an integrated circuit by transferring a minute circuit pattern onto a wafer has hitherto been widely utilized. With the trend toward a higher degree of integration and higher function of an integrated circuit, the refinement of the integrated circuit is advancing. The exposure tool is hence required to form a circuit pattern image with high resolution on a wafer surface at a long focal depth, and shortening of the wavelength of an exposure light source is being advanced. The exposure light source is further advancing from conventional g-line (wavelength: 436 nm), i-line (wavelength: 365 am) and a KrF excimer laser (wavelength: 248 nm), and an ArF excimer layer (wavelength: 193 nm) is coming to be employed. Also, in order to cope with a next-generation integrated circuit whose line width of the circuit pattern will become 70 nm or less, an immersion lithography technique and a double exposure technique, each using an ArF excimer laser, are regarded as being leading. However, it is considered that even these techniques would be able to cover only the generation with a line width of up to 45 nm.

Under the foregoing technical trends, a lithography technique using, as an exposure light source, light having a wavelength of 13 nm to represent EUV light is considered to be applicable over generation in which a line width of the circuit pattern is 32 nm and thereafter, and is attracting attention. The principle of image formation of EUV lithography (hereinafter referred to as "EUVL") is identical with that of the conventional lithography from the viewpoint that a mask pattern is transferred using a projection optical system. However, since there is no material capable of transmitting light therethrough in the EUV light energy region, a refractive optical system cannot be used. Accordingly, the optical systems are all reflecting optical systems.

The optical member of an exposure tool for EUVL includes a photomask and a mirror and is basically configured with (1) a substrate, (2) a reflective multilayer formed on the substrate and (3) an absorber layer formed on the reflective multilayer. For the reflective multilayer, forming an Mo/Si reflective multilayer in which an Mo layer and an Si layer are alternately laminated is investigated; and for the absorber layer, Ta and Cr are investigated as a layer-forming material. For the substrate, a material having a low coefficient of linear thermal expansion is required so as not to generate a strain even under irradiation with EUV light, and a glass having a low coefficient of linear thermal expansion or the like is investigated.

The $TiO_2$-$SiO_2$ glass is known as an extremely low thermal expansion material having a coefficient of linear thermal expansion (coefficient of thermal expansion: CTE) lower than that of a silica glass. Also, since the coefficient of linear thermal expansion can be controlled by the $TiO_2$ content in glass, a zero-expansion glass whose coefficient of linear thermal expansion is close to 0 can be obtained. Accordingly, the $TiO_2$-$SiO_2$ glass involves a possibility as a material to be used in an optical member of an exposure tool for EUVL.

According to the conventional preparation method of a $TiO_2$-$SiO_2$ glass, first of all, a silica precursor and a titania precursor are each converted into a gas phase and then mixed with each other. The mixture in a gas phase is introduced into a burner and thermally decomposed, thereby forming $TiO_2$-$SiO_2$ glass particles. This $TiO_2$-$SiO_2$ glass particle is deposited in a refractory container and melted therein simultaneously with the deposition, thereby forming a $TiO_2$-$SiO_2$ glass.

Also, Patent Document 1 discloses a method in which a $TiO_2$-$SiO_2$ porous glass body is formed and converted into a glass body, and a mask substrate is then obtained.

When an optical member of an exposure tool for EUVL is used in an exposure tool for EUVL, the temperature of the member rises locally because EUV light of high energy is irradiated. For this reason, it is preferred that an optical member of an exposure tool for EUVL has a broad temperature region where a coefficient of linear thermal expansion is substantially zero. However, in Patent Document 2, the present inventors disclose a $TiO_2$-$SiO_2$ glass having a fictive temperature of 1,200°C or lower, a F concentration of 100 ppm or higher and a coefficient of linear thermal expansion at 0 to 100°C of 0 ± 200 ppb/°C, and a method for producing the $TiO_2$-$SiO_2$ glass.

Since the $TiO_2$-$SiO_2$ glass has a broad temperature range in which a temperature variation of the coefficient of linear thermal expansion is small, that is, the coefficient of linear thermal expansion is substantially zero, and has high uniformity of the coefficient of linear thermal expansion and mechanical properties in the glass, it has been considered to be very suitable as a material for a member constituting an optical system used for EUVL.

Related Art

Patent Document

Patent Document 1: US 2002/157421
Patent Document 2: JP-A-2005-104820

Disclosure of Invention

Problems to be Solved by the Invention

In order to increase throughput of the exposure tool for EUVL, it is effective to increase the EUV light energy to be used for the exposure. Therefore, in that case, there is a possibility that the temperature of the member rises exceeding an estimated temperature. Specifically, since there is a possibility that the temperature rises to the range of from 40 to 110°C, it is preferred that the expansion is substantially zero at the above-mentioned temperature. This is in an effort to, in the case of a photomask or the like, prevent a change in pitch of a pattern, and in the case of a stepper mirror or the like, prevent a change in shape.

In addition, if there is a large change in dimension when the temperature increases from room temperature to a temperature at which an exposure tool for EUVL is used, the pitch or shape of the pattern varies from a state at room temperature, which may cause a possibility that optical design of the optical member becomes complicated. Accordingly, it is preferred that an optical member for an exposure tool in which high EUV energy light is used for the purpose of an increase of throughput has a low average coefficient of linear thermal expansion at from room temperature to a temperature of 40 to 110°C.

However, in the above conventional art, the temperature range in which a coefficient of linear thermal expansion is substantially zero is broad but the temperature at which zero expansion is attained is room temperature. Accordingly, the coefficient of linear thermal expansion at a temperature of 40 to 110°C does not reach zero and there is a possibility that a change in dimension or shape cannot be neglected. In addition, since the average coefficient of linear thermal expansion at from room temperature to a temperature of 40 to 110°C is high, a problem is considered that the optical design of the optical member may be complicated.

Further, in the above conventional art, since the scratch- or wear-resistance is inferior to that of common quartz glass despite uniform mechanical properties, the polishing rate is higher than that of common quartz glass, making it difficult to achieve an intended shape by polishing. Further, for the same reason, in handling methods that have been used in conventional lithography technologies, there is a risk that defects of glass may be formed or particles may be generated.

In order to solve the foregoing problems of the conventional technologies, an object of the present invention is to provide a $TiO_2$-$SiO_2$ glass having suitable thermal expansion properties as an optical member for an exposure tool in which high EUV energy light is used for the purpose of an increase of throughput, and good mechanical properties. More specifically, an object of the present invention is to provide a $TiO_2$-$SiO_2$ glass whose coefficient of linear thermal expansion is substantially zero upon irradiation with high EUV energy light when used as an optical member of an exposure tool for EUVL and which has excellent scratch- or wear-resistance.

Means for Solving the Problems

The present invention provides a $TiO_2$-containing silica glass (hereinafter, referre< to as "$TiO_2$-$SiO_2$ glass of the present invention") having a $TiO_2$ content of 7.5 to 12% by mass, a fictive temperature of 1,000°C or higher, and a temperature (Cross-over Temperature: COT) at which a coefficient of linear thermal expansion (CTE) is 0 ppb/°C being within the range of 40 to 110°C.

In the $TiO_2$-containing silica glass of according to the present invention, a $Ti^{3+}$ concentration is preferably 8 ppm by mass or lower.

Further, an OH concentration is preferably 600 ppm by mass or lower.

Further, a variation width of the fictive temperature in the depth direction in the region from the surface to a depth of 10 $\mu$m is preferably 50°C or less.

Additionally, the glass surface is preferably chemically etched.

Further, the TiO2-containing silica glass according to the present invention can be used as an optical member for EUV lithography.

Effects of the Invention

The $TiO_2$-$SiO_2$ glass of the present invention is very suitable as an optical member of an exposure tool for ELTVL because it has a very low average coefficient of linear thermal expansion from room temperature against the temperature increase at the time of irradiation with high EUV energy light, and has a coefficient of linear thermal expansion of substantially zero at the time of irradiation with high EUV energy light. In addition, the $TiO_2$-$SiO_2$ glass of the present invention possesses good mechanical properties and has excellent scratch- or wear-resistance.

Brief Description of the Drawings

Fig. 1 is a diagram illustrating the results of measurement of electron spin resonance (ESR) of a $TiO_2$-$SiO_2$ glass.
Fig. 2 is a diagram illustrating the temperature variation of the coefficients of linear thermal expansion of glasses of Examples 1 to 6 of the present invention.

Mode for Carrying out the Invention

Hereinafter, the $TiO_2$-$SiO_2$ glass of the present invention will be explained.

The $TiO_2$-$SiO_2$ glass of the present invention has a temperature (Cross-over temperature: COT), at which the coefficient of linear thermal expansion (CTE) becomes 0 ppb/°C , being within the range of 40 to 110°C.

In carrying out EUVL, for the purpose of preventing a change in dimension or shape due to a change in the temperature of an optical member such as a mirror, it is preferred that the CTE of the optical member placed in an exposure tool is low. It is suggested that the temperature of an optical member rises locally, particularly in a member close to a light source, because EUV light of high energy is irradiated thereon. The temperature of the optical member is assumed to increase to 40 to 110°C although it depends on conditions of the EUV light irradiation, In the $TiO_2$-$SiO_2$ glass of the present invention, the COT is more preferably within the range of 45 to 100°C, and particularly preferably within the range of 50 to 80°C.

In the $TiO_2$-$SiO_2$ glass of the present invention, it is preferred that the average coefficient of linear thermal expansion at 20 to 100°C is 50 ppb/°C or lower. Thus, upon irradiation with high-energy EUV light, even when the temperature of the optical member rises from room temperature to a higher temperature, the change in dimension or shape can be reduced. The average coefficient of linear thermal expansion at 20 to 100°C is more preferably 40 ppb/°C or lower, and particularly preferably 30 ppb/°C or lower.
Meanwhile, in the case where the COT is a high temperature, specifically, in the case where the COT is 50°C or higher, the average coefficient of linear thermal expansion at 20 to 100°C is liable to be a negative value. It is preferred for the same reasons that an absolute value of the average coefficient of linear thermal expansion at 20 to 100°C is small. The average coefficient of linear thermal expansion at 20 to 100°C is preferably - 120 ppb/°C or higher, more preferably -100 ppb/°C or higher, and even more preferably - 60 ppb/°C or higher. In the case where it is intended to make the change in dimension or shape at the time of irradiation with high-energy EUV light smaller, the average coefficient of linear thermal expansion at 20 to 100°C is preferably -50 ppb/°C or higher, more preferably -40 ppb/°C or higher, and particularly preferably -30 ppb/°C or higher.

The COT and average coefficient of linear thermal expansion at 20 to 100°C of the $TiO_2$-$SiO_2$ glass can be determined by measuring the coefficient of linear thermal expansion (CTE) of the $TiO_2$-$SiO_2$ glass by a known method, for example, by using a laser interferometric thermal dilatometer in the temperature range of-150 to + 200°C.

It is known that the coefficient of linear thermal expansion of the $TiO_2$-$SiO_2$ glass varies with the concentration of $TiO_2$ contained therein (see, for example, P.C. Schultz and H.T. Smyth, in: R.W. Douglas and B. Ellis, Amorphous Materials, Willey, New York, p.453 (1972)).

Accordingly, it is possible to adjust the COT of the $TiO_2$-$SiO_2$ glass by adjusting the $TiO_2$ content of the $TiO_2$-$SiO_2$ glass.

The $TiO_2$-$SiO_2$ glass of the present invention has the $TiO_2$ content of from 7.5 to 12% by mass. Within this range, the COT tends to fall in the range of 40 to 110°C.

Specifically, if the $TiO_2$ content is less than 7.5% by mass, the COT tends to be lower than 40°C. Meanwhile, if the $TiO_2$ content exceeds 12% by mass, there are problems that the COT tends to exceed 110°C or negative expansion tends to occur in the range of -150 to 200°C. Also, there is a possibility that a crystal such as rutile or the like is easily precipitated, or bubbles are easy to remain. The $TiO_2$ content is preferably 11% by mass or less, and more preferably 10% by mass or less. Also, the $TiO_2$ content is preferably 8.0% by mass or more, and more preferably 8.5% by mass or more.

When the $TiO_2$-$SiO_2$ glass of the present invention is used as an optical member of an exposure tool for EUVL, it is preferred to make the $TiO_2/SiO_2$ composition ratio in the glass uniform, from the standpoint of reducing a variation of the coefficient of linear thermal expansion in the glass. Specifically, a variation width of $TiO_2$ concentration ($\Delta TiO_2$) in an optical member of an exposure tool for EUVL in which the $TiO_2$-$SiO_2$ glass of the present invention is used is preferably within $\pm$ 0.15% by mass, more preferably within $\pm$ 0.13% by mass, particularly preferably within $\pm$ 0.10% by mass, and most preferably within $\pm$ 0.07% by mass.

The $TiO_2$-$SiO_2$ glass of the present invention has a fictive temperature of 1,000°C or higher. The present inventors have found that since the fictive temperature is associated with scratch- or wear-resistance, more specifically, the hardness of the glass increases with increasing fictive temperature, the size of scratches formed upon contact with an object becomes small, resulting in improved scratch- or wear-resistance. In common glass such as soda-lime glass, as the fictive temperature increases, the density, hardness and Young's modulus decrease, resulting in deterioration of scratch- or wear-resistance.

However, it was found that in the $TiO_2$-$SiO_2$ glass, which shows a behavior opposite to that of common glass such as soda-lime glass, as the fictive temperature increases, the density increases, the Young's modulus rises slightly and the hardness increases.

If the fictive temperature is lower than 1,000°C, the Vickers hardness is lowered, resulting in deterioration of scratch- or wear-resistance. In the $TiO_2$-$SiO_2$ glass of the present invention, the fictive temperature is preferably 1,050°C or more, more preferably 1,100°C or more, particularly preferably 1,150°C, and most preferably 1,200°C or more.

In order to obtain the $TiO_2$-$SiO_2$ glass of the present invention which has a fictive temperature of 1,000°C or higher, a method is effective in which a $TiO_2$-$SiO_2$ glass body is maintained at a temperature of 1,200°C or higher for 2 hours or more and is then cooled at an average cooling rate of 1°C/hr or more. The Examples as described below shows that a $TiO_2$-$SiO_2$ glass having a fictive temperature of 1,170°C was obtained by, according to the above method, maintaining a $TiO_2$-$SiO_2$ glass molded body at 1,200°C for 10 hours, successively cooling to 900°C at a rate of 600°C/hr, cooling to 700°C at a rate of 100°C/hr, followed by natural cooling in air. When the average cooling rate is higher, a higher fictive temperature is achieved.

Further, a high fictive temperature is achieved when the glass is obtained by natural cooling from a temperature of 1,200°C or higher in a furnace and a higher fictive temperature is achieved when the glass is obtained by rapid cooling in air from a temperature of 1,200°C or higher.

However, when a large glass body, specifically a glass body having a size of 20 kg or more, is cooled at a considerably high rate, specifically 300°C/hr or more, for example, rapidly cooled in air, there is a risk that a variation of the fictive temperature inside the glass body may become large.

The fictive temperature of the $TiO_2$-$SiO_2$ glass can be measured by known procedures. In the Examples as described below, the fictive temperature of the $TiO_2$-$SiO_2$ glass was measured by the following procedure.

With respect to a mirror-polished $TiO_2$-$SiO_2$ glass, an absorption spectrum is obtained by an infrared spectrometer (Magna 760, manufactured by Nikolet Company, was used in the Examples as described below). In this measurement, a 2 mm thick sample is used. For the absorption spectrum, a data-taking interval is set up at about 0.5 $cm^{-1}$, and an average value obtained by scanning 64 times is employed. In the infrared absorption spectrum thus obtained, a peak observed at around about 2,260 $cm^{-1}$ is attributed to an overtone of stretching vibration by a Si-O-Si bond of the $TiO_2$-$SiO_2$ glass. A calibration curve is prepared from glasses of the same composition each having a known fictive temperature by using this peak position, thereby determining the fictive temperature. A shift of the peak position by a change in the glass composition can be extrapolated from the composition dependency of the calibration curve.

When the $TiO_2$-$SiO_2$ glass of the present invention is used as an optical member o: an exposure tool for EUVL, it is preferred to make the fictive temperature in the glass uniform, not only from the standpoint of reducing a variation of the coefficient of linear thermal expansion in the glass, but also from the standpoint of making a polished state uniform to easily obtain a prescribed shape.

In the $TiO_2$-$SiO_2$ glass of the present invention, a variation of the fictive temperature is preferably within 50°C, and more preferably within 30°C. When the variation of the fictive temperature exceeds the foregoing range, there is a concern that a difference in the coefficient of linear thermal expansion is generated depending upon the site.

In this specification, the "variation of the fictive temperature" is defined as a difference between a maximum value and a minimum value of the fictive temperature inside an arbitrary glass block of 50 mm $\times$ 50 mm $\times$ 2 mm.

The variation of the fictive temperature can be measured as follows. A transparent $TiO_2$-$SiO_2$ glass body formed in a prescribed size is sliced to form a $TiO_2$-$SiO_2$ glass block of 50 mm $\times$ 50 mm $\times$ 2 mm. With respect to the 50 mm $\times$ 50 mm plane of this $TiO_2$-$SiO_2$ glass block, by measuring a fictive temperature at intervals of a 10 mm pitch according to the foregoing method, the variation of the fictive temperature of the formed $TiO_2$-$SiO_2$ glass body is determined. The glass block of 50 mm $\times$ 50 mm $\times$ 2 mm may be cut in any manner and it is preferred that a variation of the fictive temperature in any cut block is within 50°C.

The present inventors have found that when the surface of a $TiO_2$-$SiO_2$ glass is polished, the fictive temperature of the polished surface is increased, resulting in deterioration of chemical durability against chemicals. Accordingly, in the case of a conventional $TiO_2$-$SiO_2$ glass, where the surface shape thereof is processed into a predetermined shape by a method removing the surface of the glass by dry etching, wet etching or the same mechanism thereof, the etching rates in the surface and inside the glass are different from each other, making it difficult to obtain the predetermined shape. It is preferred that the TiO$_2$-SiO$_2$ glass of the present invention has a variation width of the fictive temperature in the depth direction in the region from the polished surface to a depth of 10 $\mu$m, that is, a difference between maximum and minimum values of the fictive temperatures in the region from the polished surface to a depth of 10 $\mu$m, of 50°C or less. The variation width of the fictive temperature in the depth direction in the region from the polished surface to a depth of 10 $\mu$m is more preferably 30°C or less, and particularly preferably 10°C or less.

In order for the variation width of the fictive temperature in the depth direction in the region from the polished surface to a depth of 10 $\mu$m to fall within the range defined above, it is effective to perform heat treatment after polishing, to perform chemical etching or the like. Meanwhile, the chemical etching referred to herein does not indicate etching for the purpose of processing the above-described surface shape into a predetermined shape but indicates chemical etching that is performed for the purpose of removing a certain amount of the target surface, that is, the entire polished surface.

When the heat treatment is performed, it is preferred that the heating temperature is 300°C or higher and 1,000°C or lower. If the heating temperature is lower than 300°C, there is a risk that heating effects cannot be attained. The heating temperature is more preferably 500°C or higher. Meanwhile, if the heating temperature exceeds 1,000°C, there is a risk that the fictive temperature of the glass may be varied, thus increasing the risk of a large variation of the fictive temperature. The heating temperature is more preferably 900°C or lower, and even more preferably 700°C or lower. As the heat treatment method, heating using an electric heater or heating by a laser may be applied. However, heating by a high energy laser such as an ultraviolet excimer laser is not preferred because there is a risk that the fictive temperature of the surface may be markedly increased.

The present inventors have found that OH concentration on the surface of a TiO$_2$-SiO$_2$ glass is associated with scratch- or wear-resistance, specifically, that a high OH concentration on the surface deteriorates the resistance to crack formation. Accordingly, the heat treatment for reducing the variation width of the fictive temperature in the depth direction in the region from the polished surface to a depth of 10 $\mu$m is preferably performed at a pressure of 13,000 Pa or lower or performed in an atmosphere where the moisture dew point at room temperature becomes -50°C or lower, to prevent an increase in the OH concentration on the surface.

As the chemical etching for reducing the variation width of the fictive temperature in the depth direction in the region from the polished surface to a depth of 10 $\mu$m, etching with an aqueous solution containing hydrofluoric acid is preferably performed. Dry etching also enables the removal of the surface layer of glass but causes a risk that components other than the glass components may be introduced. The present inventors have found that in a TiO$_2$-SiO$_2$ glass, a region where the fictive temperature is increased by commonly performed polishing is about 0.5 $\mu$m. Accordingly, an etching amount is preferably 0.5 $\mu$m or more, and more preferably 1 $\mu$m or more. Meanwhile, if the etching amount is excessively large, there is a risk that the surface properties may be worsened. Accordingly, the etching amount is preferably 50 $\mu$m or less, more preferably 20 $\mu$m or less, further preferably 10 $\mu$m or less, and particularly preferably 5 $\mu$m or less.

The fictive temperature of the TiO$_2$-SiO$_2$ glass surface can be measured by known procedures. In the Examples as described below, the fictive temperature of the TiO$_2$-SiO$_2$ glass surface was measured by the following procedure.

With respect to a TiO$_2$-SiO$_2$ glass surface, a reflection spectrum is obtained by an infrared spectrometer (Magna 760, manufactured by Nikolet Company, was used in the Examples as described below). In this measurement, a data-taking interval is set up at about 0.5 cm$^{-1}$, and an average value obtained by scanning 64 times is employed for the reflection spectrum. In the infrared reflection spectrum thus obtained, a peak observed at around about 1,120 cm$^{-1}$ is attributed to stretching vibration by a Si-O-Si bond of the TiO$_2$ - SiO$_2$ glass. A calibration curve is prepared from glasses of the same composition each having a known fictive temperature by using this peak position, thereby determining the fictive temperature. A shift of the peak position by a change in the glass composition can be extrapolated from the composition dependency of the calibration curve. Meanwhile, the fictive temperature of the surface that can be measured by this method is a fictive temperature in the region from the surface to a depth of about 0.2 $\mu$m. Accordingly, the fictive temperature measured by this method is conceivable to be a fictive temperature of the shallow surface.

The variation width of the fictive temperature in the depth direction in the region from the polished surface to a depth of 10 $\mu$m is measured by the following procedure. First, the fictive temperature of the polished glass surface is determined from the infrared reflection spectrum measured by the above method. Thereafter, the sample is dipped in an aqueous solution of 25% by mass of hydrofluoric acid at 25°C for 30 seconds to etch the surface, and an infrared reflection spectrum is measured to determine the fictive temperature. The etching amount in this treatment can be calculated by dividing a change in weight before and after dipping in the aqueous solution of hydrofluoric acid by the entire surface area of the measuring sample. The etching rate can be calculated by dividing the calculated etching amount by etching time, Thereafter, the sample is again dipped in the aqueous solution of 25% by mass of hydrofluoric acid at 25°C for 30 seconds to etch the surface, and an infrared reflection spectrum is measured to determine the fictive temperature. In the same manner as above, the etching amount and the etching rate are calculated. This procedure is repeated until the etching amount reaches 10 $\mu$m. The difference between maximum and minimum values of the obtained measured fictive temperatures is defined as the variation width of the fictive temperature in the depth direction in the region from the polished surface to a depth of 10 $\mu$m.

It is preferred in terms of scratch- or wear-resistance that the $TiO_2$-$SiO_2$ glass of the present invention has an OH concentration of 600 ppm by mass or less. 200 ppm by mass or less is more preferred, 100 ppm by mass or less is even more preferred, and 50 ppm by mass or less is particularly preferred.

The OH concentration of the $TiO_2$-$SiO_2$ glass can be measured by a known method. For example, the OH concentration can be determined from an absorption peak at a wavelength of 2.7 $\mu$m, as measured using an infrared spectrophotometer (J. P. Williams et. al., American Ceramic Society Bulletin, 55 (5), 524, 1976). The detection limit of this method is 0.1 ppm by mass.

The $TiO_2$-$SiO_2$ glass of the present invention has an internal transmittance per mm in thickness in the entire wavelength range of 400 to 700 nm (hereinafter, referred to as internal transmittance $T_{400-700}$) of, preferably, 80% or higher. If it is lower than 80%, visible light is easily absorbed, and as a result, there is a possibility that problems may arise in inspection or evaluation, for example, it becomes difficult to discriminate the presence or absence of internal defects such as bubbles or striae by microscopic or visual inspection. Further, in the case of a member where transmission of visible light is required for use, since the intensity of transmitting light is lowered during use, there is a possibility that the characteristics of the member may be impaired. It is more preferably 85% or more, and particularly preferably 90% or more.

The $TiO_2$-$SiO_2$ glass of the present invention has an internal transmittance per mm in thickness in the entire wavelength range of 300 to 700 nm (hereinafter, referred to as internal transmittance $T_{300-700}$) of, preferably 70% or higher, more preferably 75% or higher, and particularly preferably 80% or higher.

The $TiO_2$-$SiO_2$ glass of the present invention has an internal transmittance per mm in thickness in the entire wavelength range of 300 to 3,000 nm (hereinafter, referred to as internal transmittance $T_{300-3,000}$) of, preferably 70% or higher, and more preferably 80% or higher. If it is lower than 70%, there is a possibility that problems may arise in inspection or evaluation, for example, it becomes difficult to perform inspections for controlling uniformity or surface smoothness by a measurement instrument using a laser interferometer. Further, in the case of a member where transmission of visible light or infrared light is required, since the intensity of transmitting light is lowered, there is a possibility that the characteristics of the member may be impaired.

The transmittance is measured as follows. A 1 mm thick mirror-polished glass can be measured using a spectrophotometer (U-3500, manufactured by Hitachi Ltd.). The internal transmittance per mm in thickness can be calculated by measuring the transmittances of samples having different thicknesses, for example, a 2 mm thick sample and 1 mm thick sample, both of which have been mirror-polished to the same degree, converting the transmittances to absorbance values, subtracting the absorbance of the 1 mm thick sample from the absorbance of the 2 mm thick sample to determine an absorbance per mm, and converting the absorbance per mm again to a transmittance to obtain the internal transmittance per mm in thickness.

For simplicity, the internal transmittance is calculated by the following method. A loss in the transmittance of quartz glass having a thickness of about 1 mm, which have been mirror-polished to the same degree, at a wavelength which is not absorbed by the quartz glass, for example, at a wavelength around 2,000 nm, is considered as a reflection loss of the front surface·back surface. The transmittance loss is converted to an absorbance, which is defined as an absorbance of reflection loss at the front surface·back surface. The transmittance of the 1 mm thick sample in a wavelength region where the transmittance is measured is converted to an absorbance, from which the absorbance of the quartz glass having a thickness of about 1 mm at around 2,000 nm is subtracted. The difference in absorbance is again converted to a transmittance, which is defined as an 'internal transmittance.'

In the present invention, the concentration of $Ti^{3+}$ is preferably 8 ppm by mass or less. If the $Ti^{3+}$ concentration exceeds 8 ppm by mass, a brown color is produced and the internal transmittance $T_{400-700}$ is lowered, and as a result, there is a possibility that problem may arise in inspection or evaluation, for example, it becomes difficult to discriminate the presence or absence of internal defects such as bubbles or striae by microscopic or visual inspection. Further, in the case of a member where transmission of visible light is required for use, since the intensity of transmitting light is lowered during use, there is a possibility that the characteristics of the member may be impaired. It is more preferably ppm by mass or less, and particularly preferably 3 ppm by mass or less.

The $Ti^{3+}$ concentration is determined by electron spin resonance (ESR) measurement. The measurement is done under the following conditions.

| | |
|---|---|
| Frequency: | Around 9.44 GHz (X-band) |
| Output: | 4 mW |
| Modulated magnetic field: | 100 kHz, 0.2 mT |
| Measurement temperature: | Room temperature |
| ESR species integration range: | 332-368 mT |

(continued)

| Sensitivity calibration: | Performed at a peak height of $Mn^{2+}$/MgO in certain amounts |
| --- | --- |

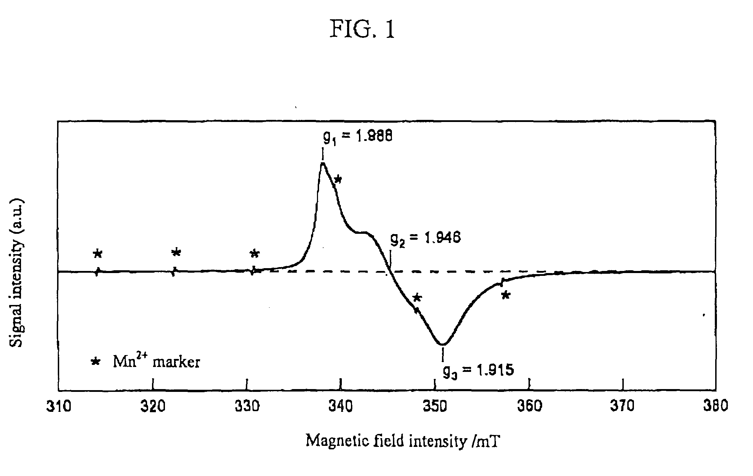

An example of the measurement on a $TiO_2$-$SiO_2$ glass is shown in Fig. 1. In Fig. 1, the ordinate represents signal intensity and the abscissa represents magnetic field intensity (mT). As a result of the measurement, the obtained signal (differential form) was a signal of a shape having anisotropy of $g_1$ = 1.988, $g_2$ = 1.946 and $g_3$ = 1.915. Since $Ti^{3+}$ in glass is usually observed at around g = 1.9, they are assumed to be signals derived from $Ti^{3+}$. The concentration of $Ti^{3+}$ was determined by comparing the intensity after twice integration with the corresponding intensity after twice integration of a standard sample whose concentration was already known.

Further, the $Ti^{3+}$ concentration can be approximately estimated from the absorption coefficient at 500 nm. The present inventors have found that the absorption coefficient $Abs_{500}$ converted from the internal transmittance at 500 nm and the $Ti^{3+}$ concentration satisfy the following relationship:

$$Ti^{3+} \text{ (ppm by mass)} = Abs_{500} \text{ (cm}^{-1}) \times 30 \qquad \text{(Formula 1)}$$

Therefore, from the results of the measurement of the internal transmittance, the $Ti^{3+}$ concentration can be calculated by Formula 1.

In the present invention, it is preferred that the ratio of variation of $Ti^{3+}$ concentration $\Delta Ti^{3+}/Ti^{3+}$ is 0.2 or less. If it exceeds 0.2, distribution of characteristics such as distribution of coloration or absorption coefficient increases. It is more preferably 0.15 or less, further preferably 0.1 or less, and particularly preferably 0.05 or less.

In this specification, "the ratio of variation of $Ti^{3+}$ concentration $\Delta Ti^{3+}/Ti^{3+}$" is defined as a value obtained by dividing the difference between maximum and minimum values of the $Ti^{3+}$ concentration by the average value of the $Ti^{3+}$ concentration, within an area of 30 mm x 30 mm in at least one plane.

The ratio of variation of $Ti^{3+}$ concentration $\Delta Ti^{3+}/Ti^{3+}$ is measured by the following procedure. In order to measure the transmittance of from an optical use surface of an optical member or a film-formed surface in the case where a film is formed (hereinafter, the optical use surface of an optical member and the film-formed surface in the case where a film is formed are collectively referred to as "optical use surface") to a depth of about 2 mm, the glass is cut, mirror polishing is performed on both surfaces thereof, and the internal transmittance is measured in accordance with the above internal transmittance measurement method. The measurement is done at 10 mm intervals from one end to the other end on an arbitrary line of the optical use surface. The absorption coefficient $Abs_{500}$ is determined from the internal transmittance at a wavelength of 500 nm to calculate the $Ti^{3+}$ concentration. The difference between the maximum and minimum values of the $Ti^{3+}$ concentration is defined as $\Delta Ti^{3+}$, and from which $\Delta Ti^{3+}/Ti^{3+}$ is determined by dividing by an average value of the $Ti^{3+}$ concentration.

It is preferred that the $TiO_2$-$SiO_2$ glass of the present invention has a variation width of the coefficient of linear thermal expansion at COT $\pm$ 3°C, $\Delta$CTE, of within $\pm$ 6 ppb/°C. If the $\Delta$CTE exceeds $\pm$ 6 ppb/°C, there is a risk that when the $TiO_2$-$SiO_2$ glass is used as an optical member of an exposure tool for EUVL, a dimensional variation due to temperature rise may be problematic. In the $TiO_2$-$SiO_2$ glass of the present invention, the $\Delta$CTE is more preferably within $\pm$ 5 ppb/°C, and particularly preferably within $\pm$ 3 ppb/°C.

The $\Delta$CTE of the $TiO_2$-$SiO_2$ glass can be measured by a known method. For example, the $TiO_2$-$SiO_2$ glass body is cut and split into small pieces of the $TiO_2$-$SiO_2$ glass of 15 mm $\times$ 15 mm $\times$ 1 mm. The coefficients of linear thermal expansion of the small pieces are measured by the foregoing method (for example, by a laser interferometric dilatometer) to determine a variation of the coefficient of linear thermal expansion of the $TiO_2$-$SiO_2$ glass body at around the COT.

It is preferred that the $TiO_2$-$SiO_2$ glass of the present invention has a Vickers hardness of 690 or more. A common silica glass exhibits a high Vickers hardness of about 780 but the addition of $TiO_2$ to silica glass causes deterioration of Vickers hardness, resulting in worsening of scratch- or wear-resistance.

Since the $TiO_2$-$SiO_2$ glass of the present invention has a high $TiO_2$ content of 7.5 to 12% by mass, as compared to conventional $TiO_2$-$SiO_2$ glasses, the Vickers hardness tends to deteriorate. However, by increasing the fictive temperature to 1,000°C or higher, the Vickers hardness can be increased. In the $TiO_2$-$SiO_2$ glass of the present invention, the Vickers hardness is more preferably 700 or higher, and particularly preferably 720 or higher. The Vickers hardness is calculated as follows. In a dry nitrogen atmosphere where the dew point is -50°C or lower, a Vickers indenter is indented against a polished surface of the glass using a Vickers hardness tester under a load of 100 gf at room temperature, the diagonal length, d ($\mu$m), of the indentation is measured. The Vickers hardness, VHN, is calculated from the diagonal length, d, of the indentation using the following formula.

$$VHN = 1854.4 \times 100/d^2$$

There are several methods for producing the $TiO_2$-$SiO_2$ glass of the present invention as follows. As one example thereof, there is a method in which $TiO_2$-$SiO_2$ glass fine particles (soot) obtained by flame hydrolysis or thermal decomposition of a silica precursor and a titania precursor each serving as glass-forming raw material are deposited and grown by a soot process, to thereby obtain a porous $TiO_2$-$SiO_2$ glass body. The obtained porous $TiO_2$-$SiO_2$ glass body is heated to a densification temperature or higher under reduced pressure or in an atmosphere where moisture concentration is low, and further heated to a transparent vitrification temperature or higher to obtain a $TiO_2SiO_2$ glass. Such soot processes includes MCVD, OVD and VAD processes depending on the preparation manner.

The densification temperature used in this specification means a temperature at which the porous glass body can be densified to such an extent that any void cannot be observed under an optical microscope. Also, the transparent vitrification temperature used herein means a temperature at which any crystal cannot be observed under an optical microscope and a transparent glass can be thus obtained.

For the purpose of manufacturing the $TiO_2$-$SiO_2$ glass of the present invention, a manufacturing method containing the following steps (a) to (e) can be adopted.

Step (a)

$TiO_2$-$SiO_2$ glass fine particles obtained through flame hydrolysis of a silica precursor and a titania precursor each serving as a glass-forming raw material are deposited and grown on a substrate, thereby forming a porous $TiO_2$-$SiO_2$ glass body. The glass-forming raw material is not particularly limited so far as it is a raw material capable of being gasified. Examples of the silica precursor include silicon halides such as chlorides, for example, $SiCl_4$, $SiHCl_3$, $SiH_2Cl_2$, $SiH_3Cl$, fluorides, for example, $SiF_4$, $SiHF_3$, $SiH_2F_2$, bromides, for example, $SiBr_4$, $SiHBr_3$, and iodides, for example, $SiI_4$; and alkoxysilanes represented by $R_nSi(OR)_{4-n}$ (wherein R represents an alkyl group having from 1 to 4 carbon atoms; n represents an integer of from 0 to 3; and the plural R may be the same as or different from each other). Also, examples of the titania precursor include titanium halides, for example, $TiCl_4$, $TiBr_4$; and alkoxytitaniums represented by $R_nTi(OR)_{4-n}$ (wherein R represents an alkyl group having from 1 to 4 carbon atoms; n represents an integer of from 0 to 3; and the plural R may be the same as or different from each other). Also, as the silica precursor and the titania precursor, a compound of Si and Ti such as a silicon titanium double alkoxide can be used.

As the substrate, a seed rod made by silica glass (for example, the seed rod described in JP-B-63-24937) can be used. Also, not only a rod form, but the substrate having a plate form may be used.

Step (b)

The porous $TiO_2$-$SiO_2$ glass body obtained in the step (a) is heated to a densification temperature under a reduced pressure of 1,300 Pa or less or in an atmosphere containing helium as a major component where the moisture dew point at room temperature is -50°C or lower, to obtain a $TiO_2$-$SiO_2$ dense body. The densification temperature is preferably from 1,250 to 1,750°C, and particularly preferably from 1,350 to 1,550°C. When the temperature is increased to a vitrification temperature under reduced pressure, an electric furnace with a metallic heater made of molybdenum as a major component is preferably used as an electric furnace. Meanwhile, in the case of using an electric furnace with a carbon heater, the pressure is preferably reduced to 130 Pa or lower and more preferably reduced to 13 Pa or lower. When the temperature is increased to a vitrification temperature in an atmosphere containing helium as a major component, it is preferred to use an electric furnace such as a muffle furnace or tube furnace made of a heat resistant material such as silica glass or alumina.

Step (c)

The $TiO_2$-$SiO_2$ dense body obtained in the step (b) is heated to a transparent vitrification temperature to obtain a transparent $TiO_2$-$SiO_2$ glass body. The transparent vitrification temperature is preferably from 1,450 to 1,750°C, and particularly from 1,550 to1,700°C. As an atmosphere, an atmosphere containing 100% of an inert gas such as helium or argon, or an atmosphere containing an inert gas such as helium or argon as a major component is preferred. The gas pressure is preferably 13,000 Pa or higher. In the case of lower than 13,000 Pa, sublimation of $SiO_2$ component at high temperature cannot be neglected. There is no special problem when the pressure becomes higher that, ambient atmospheric pressure. Meanwhile, "Pa" in this specification means an absolute pressure, not a gauge pressure.

Step (d)

The transparent TiO$_2$-SiO$_2$ glass body obtained in the step (c) is heated to a softening point or higher and formed into a desired shape, to obtain a formed TiO$_2$-SiO$_2$ glass body. The temperature in the forming treatment is preferably from 1,600 to 1,800°C. When the temperature is 1,600°C or higher, the viscosity of the transparent TiO$_2$-SiO$_2$ glass sufficiently decreases to a degree where deformation due to own weight substantially proceeds. Also, the growth of cristobalite which is a crystal phase of SiO$_2$, or the growth of rutile or anatase which is a crystal phase of TiO$_2$ hardly occurs, therefore, the occurrence of so-called devitrification can be prevented. When the forming temperature is 1,800°C or lower, sublimation of SiO$_2$ can be suppressed. As an atmosphere, an atmosphere containing 100% of an inert gas such as helium or argon, or an atmosphere containing an inert gas such as helium or argon as a major component is preferred. The pressure is preferably 13,000 Pa or higher. In the case of lower than 13,000 Pa, sublimation of SiO$_2$ at high temperature cannot be neglected. There is no special problem when the pressure becomes higher than ambient atmospheric pressure.

The step (c) and the step (d) can be carried out continuously or simultaneously.

Step (e)

The formed TiO$_2$-SiO$_2$ glass body obtained in the step (d) is maintained at a temperature of 1,000°C or higher for two hours or more and then subjected to an annealing treatment for decreasing the temperature to 700°C or lower at an average temperature-decreasing rate of more than 10°C/hr, thereby controlling the fictive temperature of the TiO$_2$-SiO$_2$ glass. Alternatively, the formed TiO$_2$-SiO$_2$ glass body obtained in the step (d) is subjected to an annealing treatment for decreasing the temperature to 700°C or lower at an average temperature-decreasing rate of more than 10°C/hr, thereby controlling the fictive temperature of the TiO$_2$-SiO$_2$ glass. In that case, the atmosphere is preferably an atmosphere of 100 % of an inert gas, such as helium, argon, or nitrogen, an atmosphere containing, as a major component, such an inert gas, or an air atmosphere; and the pressure is preferably a reduced pressure or normal pressure.

It is preferred that the TiO$_2$-SiO$_2$ glass of the present invention is free from an inclusion having a size of 10 $\mu$m or more. It is more preferred that there is no inclusion having a size of 10 $\mu$m or more, further preferred that there is no inclusion having a size of 1 $\mu$m or more, and particularly preferred that there is no inclusion having a size of 100 nm or more. The inclusion as referred to herein means a foreign matter, a bubble or the like existing in the glass. There is a concern that the foreign matter is generated by contamination or crystal precipitation in a glass manufacturing process. In order to eliminate the inclusion, such as a foreign matter or a bubble, it is necessary to suppress the contamination in the above manufacturing process, especially in the step (a), and further to precisely control the temperature conditions of the steps (b) to (d).

Examples

The present invention will be illustrated in greater detail with reference to the following Examples, but the invention should not be construed as being limited thereto.

Examples 1 to 4 are invention examples, and the remainder is comparative examples.

[Example 1]

TiO$_2$-SiO$_2$ glass fine particles obtainable by gasifying TiCl$_4$ and SiCl$_4$ each serving as a glass-forming raw material of a TiO$_2$-SiO$_2$ glass, respectively, and then mixing them and subjecting to heat hydrolysis (flame hydrolysis) in an oxyhydrogen flame, is deposited and grown on a substrate, thereby forming a porous TiO$_2$-SiO$_2$ glass body (step (a)).

Since it is hard to handle the obtained porous TiO$_2$-SiO$_2$ glass body without any treatment, it is maintained in air at 1,200°C for 6 hours together with the substrate and the separated from the substrate.

Thereafter, the porous TiO$_2$-SiO$_2$ glass body is placed in an electric furnace having a metallic heater made of molybdenum as a major component, and the pressure is reduced to 1,300 Pa at room temperature. Thereafter, the temperature is increased to 1,450°C, and the system is maintained at this temperature for 4 hours, thereby obtaining a TiO$_2$-SiO$_2$ dense body (step (b)).

The obtained TiO$_2$-SiO$_2$ dense body is heated to 1,700°C in an argon atmosphere using a furnace having a carbon heater, thereby obtaining a transparent TiO$_2$-SiO$_2$ glass body (step (c)).

The obtained transparent TiO$_2$-SiO$_2$ glass body is heated to a temperature of a softening point or higher (1,750°C) under an argon atmosphere under ambient atmospheric pressure and formed in a desired shape, thereby obtaining a formed TiO$_2$-SiO$_2$ glass body (step (d)).

The obtained glass is maintained at 1,200°C for 10 hours under an air atmosphere under ambient atmospheric pressure, and then subjected to temperature decrease to 900°C at a rate of 600°C/hr and subjected to temperature decrease to 700°C at a rate of 100°C/hr followed by natural cooling in air (step (e)).

The obtained glass body is cut using a slicer, shaped into a plate using a longitudinal grinder, and polished using a 20B double-sided lapper (manufactured by Speedfam Co., Ltd.) and using a slurry in which 18 to 20% by mass of GC#400 (product name, manufactured by Fuji Corporation) composed substantially of SiC is suspended in filtered water as an abrasive. Subsequently, as a primary polishing, both surfaces are polished about 50 $\mu$m in total using a 20B double-sided polisher, LP66 (product name, manufactured by Rhodes) made of urethane as a polishing cloth, and a slurry in which, as an abrasive, 10 to 12% by mass of MIREK 801A (product name, manufactured by Mitsui Mining & Smelting Co., Ltd.) composed of cerium oxide as a major component is suspended. Furthermore, both surfaces are polished about 10 $\mu$m in total (secondary polishing) using a 20B double-sided polisher and Siegal 7355 (product name, manufactured by Toray Coatex Co., Ltd.) made of foamed urethane as a polishing cloth, and final polishing (tertiary polishing) is carried out using a 24B double-sided polisher (manufactured by Hamai Co., Ltd.). For the final polishing, colloidal silica (Compol 20, product name, manufactured by Fujimi Corporation) is used as an abrasive and Bellatrix K7512 (product name, manufactured by Kanebo) is used as a polishing cloth. Washing i performed using a hot solution of sulfuric acid and a hydrogen peroxide solution and a neutral surfactant solution, and chemical etching is performed using a 25% aqueous solution of hydrofluoric acid at room temperature for 3 minutes, to thereby obtain a glass.

[Example 2]

A $TiO_2$-$SiO_2$ glass body is obtained in the same manner as in Example 1, except that the amount of $TiCl_4$ supplied is reduced in the step (a) in Example 1, and the glass is maintained at 1,120°C for 10 hours, subjected to temperature decrease to 900°C at a rate of 600°C/hr, and subjected to temperature decrease to 700°C at a rate of 100°C/hr, followed by natural cooling in air in the step (c).

[Example 3]

A $TiO_2$-$SiO_2$ glass body is obtained in the same manner as in Example 1, except that the amount of $TiCl_4$ supplied is slightly reduced in the step (a) in Example 1, and the formed $TiO_2$-$SiO_2$ glass body obtained in the step (d) is directly cooled to 900°C at a rate of 600°C/hr, and cooled to 700°C at a rate of 100°C/hr, followed by natural cooling in air in the step (e).

[Example 4]

A $TiO_2$-$SiO_2$ glass body is obtained in the same manner as in Example 1, except that the amount of $TiCl_4$ supplied is reduced in the step (a) in Example 1, and the glass is maintained at 1,150°C for 10 hours, subjected to temperature decrease to 900°C at a rate of 600°C/hr, and subjected to temperature decrease to 700°C at a rate of 100°C/hr, followed by natural cooling in air in the step (e).

[Example 5]

A $TiO_2$-$SiO_2$ glass body is obtained in the same manner as in Example 1, except that the amount of $TiCl_4$ supplied is reduced in the step (a) in Example 1, and the glass is maintained at 1,200°C for 10 hours, subjected to temperature decrease to 900°C at a rate of 150 °C/hr, and subjected to temperature decrease to 700°C at a rate of 100°C/hr, followed by natural cooling in air in the step (e).

[Example 6]

ULE#7972 (manufactured by Coming) known as a zero-expansion $TiO_2$-$SiO_2$ glass is cut, ground and polished in the same manner as in Example 1.

[Example 7]

A $TiO_2$-$SiO_2$ glass body is obtained in the same manner as in Example 1, except that the final chemical etching with hydrofluoric acid is not performed in Example 1.

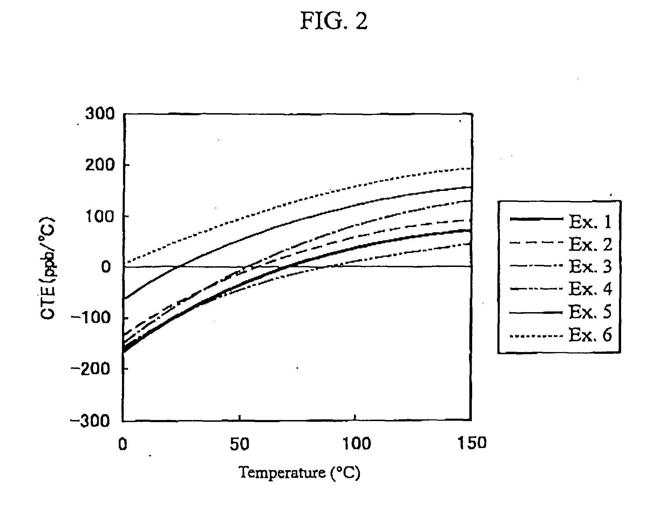

The measurement results of the physical properties of the glasses produced in the above Examples 1 to 6 are summarized in Tables 1 and 2. The evaluations are conducted in accordance with each of the above-described measurement methods. The COT values shown in Table 2 are derived by obtaining temperatures at which the coefficients of linear thermal expansion become 0 ppb/°C from the curve of Fig. 2. In each of the glasses, $\Delta TiO_2$ was within $\pm$ 0.07% by mass, the variation of fictive temperature was within 30°C, $\Delta Ti^{3+}/Ti^{3+}$ was 0.05 or less, and $\Delta CTE$ was within $\pm$ 5 ppb/°C.

[Table 1]

| | TiO$_2$ concentration (% by mass) | Fictive Temperature (°C) | OH concentration (ppm by mass) | Ti$^{3+}$ concentration (ppm by mass) | Vickers hardness |
|---|---|---|---|---|---|
| Example 1 | 9.2 | 1170 | . 40 | 7 | 710 |
| Example 2 | 7.9 | 1100 | 40 | 2 | 700 |
| Example 3 | 9 | 1330 | 40 | 5 | 725 |
| Example 4 | 8,4 | 1120 | 40 | 6 | 710 |
| Example 5 | 6.7 | 1070 | 40 | 7 | 685 |
| Example 6 | 7.4 | 900 | 880 | 1 | 680 |

[Table 2]

| | COT (°C) | Average coefficient of linear thermal expansion at 20-100°C (ppb/°C) | T$_{400-700}$ (%) | T$_{300-700}$ (%) | T$_{300-3000}$ (%) |
|---|---|---|---|---|---|
| Example 1 | 71.6 | -29.0 | > 93.8 | > 88.9 | > 88.9 |
| Example 2 | 56.7 | -3.9 | >96.8 | > 91.4 | > 90.8 |
| Example 3 | 53.2 | 3.6 | > 94.2 | > 88.8 | > 88.8 |
| Example 4 | 86.6 | -38.8 | > 94.0 | > 88.6 | > 88.6 |
| Example 5 | 24.3 | 61.0 | > 93.6 | > 88.5 | > 88.5 |
| Example 6 | -2.4 | 103.3 | > 95.9 | > 89.6 | > 12.5 |

The variation widths of the fictive temperature in the depth direction in the region from the surface to depth of 10 μm with regard to the glasses of Examples 1 and 7 were examined by the above-described method, and as a result, they were 7°C and 77°C, respectively. A Vickers indenter was indented against each of the glasses under a load of 100 gf in a dry nitrogen atmosphere where the dew point is -80°C, and after 30 seconds, the vicinity of the indentation was observed. As a result, no crack was formed in the glass of Example 1 and cracks were formed around the indentation in the glass of Example 7.

As is clear from Tables 1 and 2, each of Examples 1 to 4 having a COT within the range of 40 to 110°C and a fictive temperature of 1,000°C or more, achieve substantially zero of the coefficient of linear thermal expansion upon irradiation with high EUV energy light, and have good scratch- or wear-resistance due to their high Vickers hardness values, therefore, they are suitable as an optical member of an exposure tool for EUVL.

While the present invention has been described in detail and with reference to specific embodiments thereof, it will be apparent to one skilled in the art that various changes and modifications can be made therein without departing from the sprit and scope of the present invention.

This application is based on Japanese Patent Application No. 2009-189899 filed on August 19, 2009, and the entire contents of which are incorporated hereinto by reference.

INDUSTRIAL APPLICABILITY

The silica glass and the optical member of the present invention are suitable for use in an exposure tool for EUV lithography. Further, they are also suitable as a substra for nanoimprinting.

**Claims**

**1.** A TiO$_2$-containin silica glass having a TiO$_2$ content of 7.5 to 12% by mass, a fictive temperature of 1,000°C or higher, and a temperature at which a coefficient of linear thermal expansion is 0 ppb/°C being within the range of 40 to 110°C.

2. The $TiO_2$-containing silica glass according to claim 1, having a $Ti^{3+}$ concentration of 8 ppm by mass or lower.

3. The $TiO_2$-containing silica glass according to claim 1 or 2, having an OH concentration of 600 ppm by mass or lower.

4. The $TiO_2$-containing silica glass according to any one of claims 1 to 3, having a variation width of the fictive temperature in the depth direction in the region from the surface to a depth of 10 $\mu$m of 50°C or less.

5. The $TiO_2$-containing silica glass according to any one of claims 1 to 4, wherein the glass surface is chemically etched.

6. An optical member for EUV lithography using the $TiO_2$-containing silica glass according to any one of claims 1 to 5.

FIG. 1

$g_1 = 1.988$

$g_2 = 1.946$

$g_3 = 1.915$

* $Mn^{2+}$ marker

Signal intensity (a.u.)

310    320    330    340    350    360    370    380

Magnetic field intensity /mT

EP 2 468 692 A1

FIG. 2

<div align="center">

**INTERNATIONAL SEARCH REPORT**

</div>

| | International application No. |
|---|---|
| | PCT/JP2010/063834 |

**A. CLASSIFICATION OF SUBJECT MATTER**
*C03C3/06*(2006.01)i, *H01L21/027*(2006.01)i

According to International Patent Classification (IPC) or to both national classification and IPC

**B. FIELDS SEARCHED**

Minimum documentation searched (classification system followed by classification symbols)
C03C1/00-14/00, C03B20/00

Documentation searched other than minimum documentation to the extent that such documents are included in the fields searched
Jitsuyo Shinan Koho        1922-1996    Jitsuyo Shinan Toroku Koho    1996-2010
Kokai Jitsuyo Shinan Koho   1971-2010    Toroku Jitsuyo Shinan Koho    1994-2010

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br>Y<br>A | JP 2008-303100 A  (Shin-Etsu Chemical Co.,<br>Ltd.),<br>18 December 2008 (18.12.2008),<br>claims<br>& US 2008/0305941 A1    & EP 2003098 A1<br>& CN 101333069 A        & KR 10-2008-0107299 A | 1-4<br>6<br>5 |
| Y | JP 2005-507353 A  (Corning Inc.),<br>17 March 2005 (17.03.2005),<br>paragraph [0001]<br>& US 2002/0157421 A1    & EP 1390309 A<br>& WO 2002/088036 A1    & TW 568889 B | 6 |
| P,X | JP 2010-163345 A  (Asahi Glass Co., Ltd.),<br>29 July 2010 (29.07.2010),<br>claims<br>(Family: none) | 1-4,6 |

| ☒ Further documents are listed in the continuation of Box C. | ☐ See patent family annex. |
|---|---|

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 27 August, 2010 (27.08.10) | 07 September, 2010 (07.09.10) |

| Name and mailing address of the ISA/ | Authorized officer |
|---|---|
| Japanese Patent Office | |
| Facsimile No. | Telephone No. |

Form PCT/ISA/210 (second sheet) (July 2009)

**INTERNATIONAL SEARCH REPORT**

International application No.

PCT/JP2010/063834

C (Continuation).   DOCUMENTS CONSIDERED TO BE RELEVANT

| Category* | Citation of document, with indication, where appropriate, of the relevant passages | Relevant to claim No. |
|---|---|---|
| A | JP 2004-315351 A  (Asahi Glass Co., Ltd.), 11 November 2004 (11.11.2004), entire text & US 2005/0245383 A1      & EP 1608599 A & WO 2004/089838 A      & WO 2004/089838 A1 & DE 602004009553 D | 1-6 |

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2002157421 A
- JP 2005104820 A
- JP 63024937 B
- JP 2009189899 A

**Non-patent literature cited in the description**

- **P.C. Schultz ; H.T. Smyth.** Amorphous Materials. Willey, 1972, 453